# FASCICULE DE BREVET EUROPEEN

(11) **EP 2 434 187 B1**
(45) Date de publication et mention de la délivrance du brevet: **19.06.2013**
(21) Numéro de dépôt: 10306019.0
(22) Date de dépôt: 22.09.2010
(51) Int. Cl.: F16K 31/02, H01L 35/28

(54) **Procédé de pilotage de vanne thermostatique**
Steuerverfahren eines Thermostatventils
Method for controlling a thermostatic valve

(43) Date de publication de la demande: 28.03.2012
(73) Titulaire: HAGER CONTROLS (Société par Actions Simplifiée), 67700 Saverne (FR)
(72) Inventeur: Kalischek, Nicolas, 67210 Bernardswiller (FR); Valance, Jean-Christophe, 57430 Kirviller (FR)
(74) Mandataire: Nuss, Laurent

(56) Documents cités:
- GB-A- 2 129 525
- GB-A- 2 278 934
- US-A1- 2004 246 752

## Description

Le domaine de la présente invention est celui des dispositifs domestiques pour le contrôle, et, en particulier, pour le contrôle et la régulation d'une installation de chauffage domestique à circulation de fluide. L'invention a pour objet un procédé de pilotage d'une vanne thermostatique.

FR-A-2 522 120 divulgue un dispositif de régulation thermostatique d'une vanne à bilame. Un tel bilame est utilisé pour déplacer, par sa déformation provoquée par la température de l'air environnant, un piston obturateur de l'entrée du radiateur. Un détecteur de température déporté du radiateur envoie du courant électrique dans le bilame, afin de rendre sa déformation dépendante de la température observé à distance de la vanne à proximité de laquelle le bilame est logé.

Toutefois, une vanne à bilame n'a pas la précision suffisante et n'est pas compatible avec une installation centralisée de contrôle domotique. En outre, un des inconvénients des réseaux de contrôle domotique est la nécessité de réaliser un câblage électrique pour fournir, d'une part, la puissance nécessaire à l'actionnement de la vanne, et, d'autre part, l'information de pilotage.

FR-A-2 762 074 divulgue l'utilisation des tuyauteries de circulation d'eau dans une installation de chauffage pour fournir à la vanne tant l'énergie électrique nécessaire à son opération que les signaux de commande. Les propriétés de conduction électrique des tuyaux utilisés sont donc exploitées pour éviter d'avoir à rajouter un réseau filaire d'alimentation et de contrôle des vannes. Néanmoins, une telle utilisation des tuyaux n'est pas forcément souhaitable pour des raisons de sécurité.

FR-A-2 788 842 divulgue une installation de chauffage utilisant des radiateurs à eau chaude, éventuellement groupés en un ou plusieurs ensembles, contrôlés par une centrale à laquelle ils sont reliés par une connexion sans fil. Les informations de contrôle sont du type : niveau et période de chauffe ou mode de fonctionnement présélectionné. Chaque radiateur est équipé d'une pile électrique ou batterie et, pour limiter le temps d'utilisation de la pile, chaque consommateur ne fonctionne que pendant le temps strictement nécessaire. Néanmoins, l'utilisation d'une pile n'est pas optimale puisqu'il est nécessaire d'en changer régulièrement, malgré une utilisation rigoureuse.

Dans le but de simplifier la connectique utilisée pour un réseau d'alimentation et de contrôle d'une installation de chauffage, EP-A-1 020 688 et EP-A-1 020 785 divulguent chacun une installation essentiellement pilotée sans fil et comprenant une unité de base qui, pour EP-A-1 020 688, incorpore des moyens de détection de l'état de la vanne thermostatique, permettant d'identifier son éventuel état bloqué, et qui, pour EP-A-1 020 785, identifie un éventuel défaut d'occupation de la ligne de communication entre l'unité de base et l'un quelconque des composants. L'autonomie énergétique n'est toutefois pas garantie.

WO-A-2009/153 331 porte, quant à lui, sur un dispositif de ventilation. Une des caractéristiques de ce dispositif est qu'il est muni d'un moyen de collecte de l'énergie de l'environnement, qui fourni l'énergie électrique au ventilateur. Dans un des modes de réalisation, un effet thermoélectrique est utilisé, à partir de la différence entre l'air extérieur et l'air circulant dans le conduit de ventilation. Une telle solution n'est toutefois pas applicable au domaine des dispositifs de chauffage par circulation de fluide, car, hors des périodes de fonctionnement, le fluide se trouve à la même température que l'environnement, rendant impossible la fourniture de l'énergie électrique nécessaire au démarrage.

L'utilisation d'un gradient de température pour créer de l'énergie électrique est bien connue depuis longtemps. A titre d'exemple, US-A-773 838 décrit déjà un dispositif de piles thermoélectriques fonctionnant avec le gradient de température entre de l'air frais et de l'air chaud. De façon générale, chaque unité formant une pile comprend deux bornes électriques, chacune faite de matière différente, reliée au niveau d'une jonction, le gradient de température étant aménagé entre, d'une part, la jonction, et, d'autre part, les bornes.

Les documents GB 2278934 et GB 2129525 divulguent aussi des procédés de pilotage pour vannes.

La présente invention a pour but de pallier tout ou partie des inconvénients précédemment cités et vise à obtenir un procédé de pilotage d'une vanne thermostatique pour installation de chauffage par circulation de fluide ne nécessitant pas d'apport en énergie électrique supplémentaire et constamment opérationnel.

A cet effet, l'invention a pour objet un procédé de pilotage d'une vanne thermostatique d'un corps de chauffage à circulation de fluide, notamment un radiateur à eau chaude, dans lequel la vanne est commandée en fonction d'une consigne. Ce procédé comprend, en outre, une étape consistant à produire l'énergie électrique pour la réalisation du procédé en utilisant un effet thermoélectrique, couramment appelé « Seebeck » ou « Peltier inversé », ainsi qu'une étape consistant à stocker l'énergie électrique produite par cet effet thermoélectrique dans un moyen d'accumulation, et, enfin, une étape de repli, consistant à vendre la vanne immobile dans une position qui laisse une ouverture par laquelle un faible débit de fuite peut circuler.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
- la figure 1 est un ordinogramme du procédé selon l'invention ;
- la figure 2 montre un dispositif apte à mettre en oeuvre le procédé selon l'invention, et
- la figure 3 illustre l'interaction entre les étapes du procédé selon l'invention.

L'invention a pour objet un procédé de pilotage d'une vanne 1 thermostatique d'un corps de chauffage à circulation de fluide, notamment un radiateur à eau chaude, dans lequel la vanne 1 est commandée en fonction d'une consigne, lors d'une étape qui consiste à commander le mouvement 101 de la vanne 1 en fonction d'une consigne.

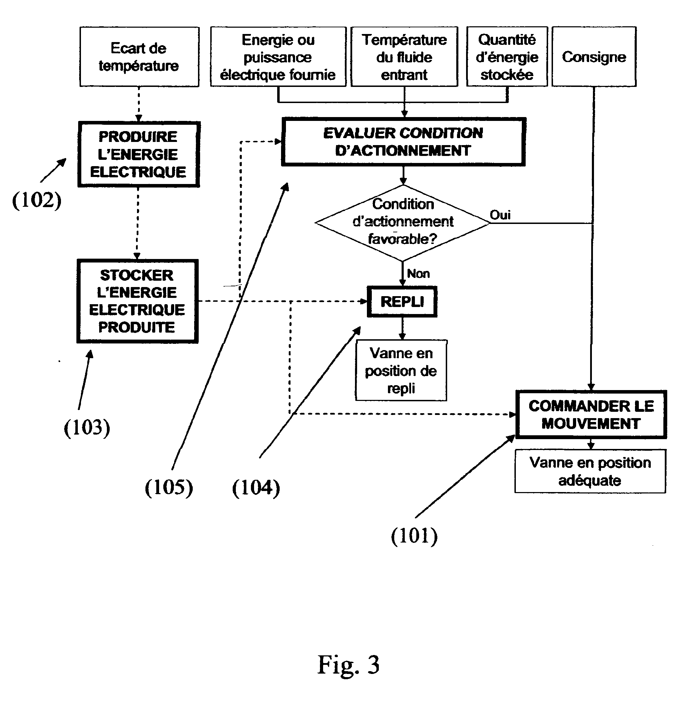

Dans la figure 3, les étapes du procédé sont représentées dans des encadrés épais et écrites en majuscule. L'alimentation en énergie électrique est représentée par des traits discontinus. Le mouvement de la vanne 1 est illustré par les traits pleins.

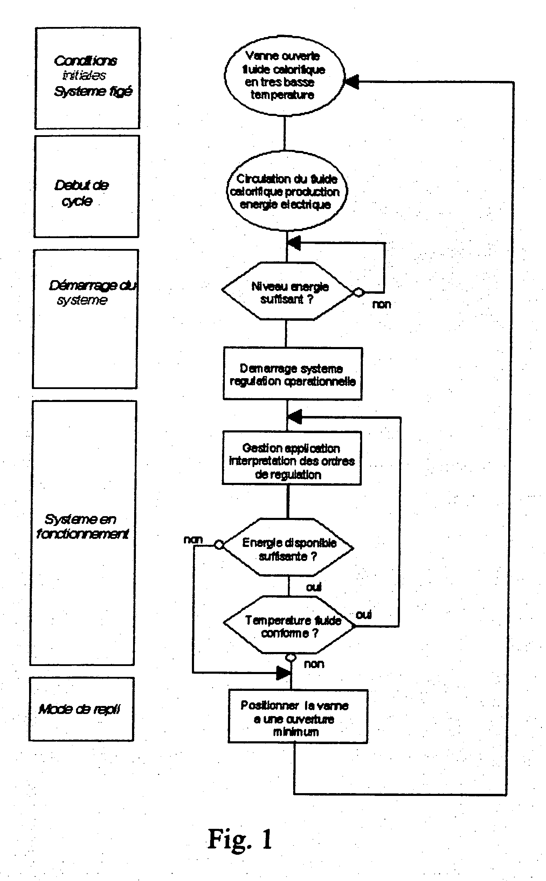

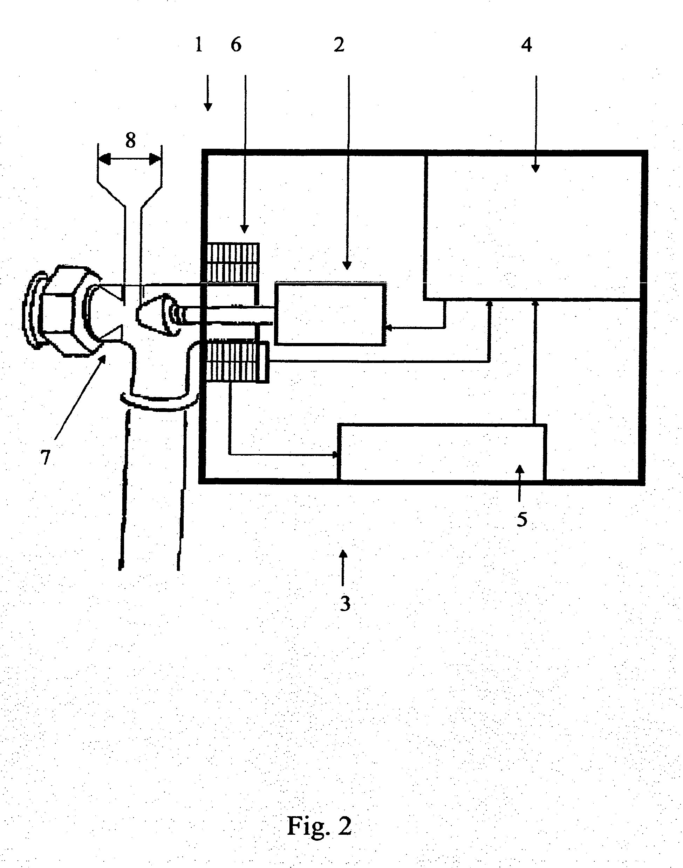

Comme le montre la figure 2, la vanne 1 thermostatique est classiquement contrôlée grâce à un actionneur indépendant ou intégré, à savoir un moteur 2 dans le mode de réalisation illustré à la figure 1, et ils font tous deux partie d'un dispositif de contrôle 3 du radiateur, qui a pour but d'adapter le débit de fluide chaud dans le radiateur à une commande de contrôle, ou consigne, donnée par un thermostat électronique. Ce dispositif de contrôle 3 comprend, en outre, des moyens électroniques 4 de réception de commande, de mesure, de calcul et aussi de pilotage de l'actionneur. La vanne 1 thermostatique est disposée à proximité du radiateur, et il est donc particulièrement avantageux, pour éviter d'installer un réseau d'alimentation ou de connexion électrique, d'utiliser un dispositif de contrôle 3 fonctionnant sans fil, et muni de sa propre source d'énergie électrique. Afin de garantir cette autonomie en énergie, la présente invention a pour objet un procédé de pilotage comprenant, en outre, une étape consistant à produire l'énergie électrique 102 pour la réalisation du procédé en utilisant un effet thermoélectrique, couramment appelé « Seebeck » ou « Peltier inversé », ainsi qu'une étape consistant à stocker l'énergie électrique produite 103 par cet effet thermoélectrique dans un moyen d'accumulation 5. Selon l'invention, le procédé comprend aussi une étape de repli 104, consistant à mettre la vanne 1 dans une configuration dans laquelle elle permet toujours une circulation du fluide, notamment une très faible circulation. Bien sûr l'étape de repli 104 peut aussi consister à ouvrir entièrement la vanne 1.

Le dispositif de contrôle 3 comprend donc un élément thermoélectrique 6 formant un moyen de production d'énergie électrique à l'aide d'un tel effet thermoélectrique, ainsi qu'un moyen d'accumulation 5 permettant le stockage de l'énergie électrique produite.

Avantageusement, l'étape consistant à produire l'énergie électrique 102 consiste à produire l'énergie électrique à partir d'une différence de température entre, d'une part, le fluide chaud, directement ou non, comme, par exemple, au niveau de la canalisation d'alimentation en fluide chaud du corps de chauffage, et, d'autre part, une substance plus froide, telle que l'air environnant ou le fluide après son passage dans le radiateur. L'énergie électrique est donc produite grâce à la chaleur du fluide qui circule.

Cet effet thermoélectrique permet la création d'énergie électrique à partir d'une différence de température. Préférentiellement, la différence de température utilisée est celle entre le fluide chaud entrant dans le radiateur et l'air extérieur. Cette transformation d'énergie peut être réalisée par un élément thermoélectrique 6 classique tel qu'un composant ThermoGenerator, générateur thermique, GTE, disposé dans la vanne 1 elle-même, au contact de la canalisation dans laquelle circule le fluide thermique. Ainsi, la différence de température entre la canalisation d'eau chaude et l'air ambiant est transformée en énergie électrique puis utilisé par le procédé.

Selon une caractéristique possible, le moyen d'accumulation 5 consiste en au moins un couple d'accumulateurs électriques, l'étape consistant à stocker l'énergie électrique produite 103 revenant alors à la stocker dans ledit au moins un couple d'accumulateurs électriques qui fournissent à leur tour l'énergie nécessaire pour la mise en oeuvre du procédé. Ainsi, l'écart de température entre le fluide entrant et l'air environnant permet la production de l'énergie électrique nécessaire à la réalisation du procédé de contrôle de la vanne 1 thermostatique, et ce en stockant l'énergie produite dans un moyen d'accumulation 5 d'énergie électrique, sous la forme d'un couple de batteries ou de capacités. L'énergie électrique est nécessaire au procédé, entre autres, pour le fonctionnement des moyens électroniques 4 de réception et de commande, la communication sans fil avec l'interface de commande, ainsi que pour le mouvement de la vanne 1.

Dans un mode de réalisation particulier, le procédé comprend une étape consistant à évaluer une condition d'actionnement 105, ladite condition d'actionnement étant définie comme favorable si la valeur d'un paramètre ou de plusieurs paramètres parmi la température du fluide entrant, la quantité d'énergie stockée dans le moyen d'accumulation 5 et l'énergie ou la puissance électrique fournie par l'effet thermoélectrique, se trouve au-dessus d'un seuil limite.

Cette condition d'actionnement est définie de la façon suivante : elle est non favorable si la quantité d'énergie stockée dans le moyen d'accumulation 5, ou/et si la température du fluide entrant dans le corps de chauffage, ou/et si la puissance ou l'énergie électrique fournie par la transformation thermoélectrique qui a lieu dans l'élément thermoélectrique 6 est/sont sous un seuil limite qui lui est propre. Différentes combinaisons logiques de ces paramètres peuvent être envisagées. Dans une première combinaison, la condition d'actionnement n'est favorable que si les trois paramètres sont au-delà de leur seuil respectif. Dans une autre combinaison, elle est favorable tant qu'au moins l'un des paramètres est au dessus de son propre seuil.

Dans le mode de réalisation de la figure 1, le démarrage, c'est-à-dire la commande du mouvement de la vanne 1 en fonction d'une consigne, n'est envisagée que si le niveau d'énergie est suffisant, c'est-à-dire si la quantité d'énergie stockée dans le moyen d'accumulation 5 est au-dessus d'un seuil propre. La condition d'actionnement pour que la position de la vanne 1 soit adaptée à la consigne est uniquement la quantité d'énergie stockée dans le moyen d'accumulation 5. Dans ce même mode de réalisation, l'étape de repli 104 consiste à positionner la vanne 1 à une ouverture minimum, et elle est déclenchée si la température du fluide n'est pas conforme, c'est-à-dire n'est pas supérieure à un seuil qui lui est propre, ou si la quantité d'énergie stockée dans le moyen d'accumulation 5 est insuffisante, c'est-à-dire sous un seuil qui lui est propre. La condition d'actionnement devient donc non favorable et déclenche ainsi l'étape de repli 104 si la température du fluide ou si la quantité d'énergie stockée est sous un seuil qui lui est propre. Ce mode de réalisation montre donc que la condition d'actionnement peut être basée sur deux combinaisons logiques différentes pour le déclenchement de l'étape de repli 104 et pour l'étape qui consiste à commander le mouvement 101.

La condition d'actionnement permet donc de détecter une situation limite à partir de laquelle il sera bientôt impossible de bouger la vanne 1. Le fait que la température du fluide entrant dans le radiateur soit sous un seuil limite est le signe de la fin, au moins temporaire, c'est-à-dire, pour au moins quelques jours, voire quelques semaines, d'une période de chauffe. Il suivra donc une période au cours de laquelle le fluide présent dans les canalisations ne sera pas assez chaud pour garantir l'alimentation électrique telle que définie plus haut, au moyen de l'élément thermoélectrique 6. De même, si la quantité d'énergie stockée descend sous un seuil limite, il peut être dangereux de tenir compte d'une consigne du thermostat. En effet, si cette consigne correspond à la fermeture complète de la vanne 1, l'actionneur sera bougé de façon à fermer entièrement la vanne 1 thermostatique, le fluide chaud ne pourra alors plus circuler, ce qui empêchera donc la formation d'énergie électrique pour la future réouverture de la vanne 1 thermostatique. La vanne 1 est alors complètement bloquée.

Cette condition d'actionnement est évaluée en permanence ou à intervalles temporels réguliers. La condition d'actionnement peut aussi tenir compte d'une date.

Selon une caractéristique avantageuse de l'invention, l'étape de repli 104 est effectuée si la condition d'actionnement n'est pas favorable. Ainsi, dès que la condition d'actionnement n'est pas favorable, et indépendamment de la consigne, la vanne 1 thermostatique est volontairement placée dans une configuration telle qu'elle peut laisser circuler au moins un peu de fluide dans le radiateur. Un ordre de grandeur suffisant pour ce débit peut être entre environ 5 et environ 100% du débit maximum qui peut circuler par la vanne 1. Dès l'envoi d'une consigne du thermostat tendant à la reprise du chauffage, la vanne 1 thermostatique, malgré son immobilité et compte tenu de la configuration dans laquelle elle se trouve, laisse donc au moins faiblement circuler le fluide chaud, ce qui permet de créer de l'énergie électrique grâce à l'élément thermoélectrique 6 précédemment décrit. Dès qu'une quantité d'électricité suffisante a été stockée dans le moyen d'accumulation 5, la condition d'actionnement redevient favorable. En effet, à la fois la quantité d'énergie électrique stockée et la température du fluide entrant sont suffisamment élevées. La vanne 1 thermostatique peut alors fonctionner normalement, et adapter sa position à la consigne du thermostat.

Lorsque la condition d'actionnement n'est pas favorable, l'étape de repli 104 est donc engagée, et la vanne 1 thermostatique est mise dans une configuration qui laisse au moins un débit de fuite, de l'ordre de 5 à 100% du débit maximal.

Tant que la quantité d'énergie électrique dans le moyen d'accumulation 5 n'a pas atteint le seuil nécessaire, il est indispensable de ne pas adapter la position de la vanne 1 thermostatique à la consigne, afin d'éviter, par exemple, de fermer complètement la vanne 1, ce qui stopperait complètement la circulation du fluide alors que la quantité d'énergie stockée à ce moment ne permettrait plus de rouvrir la vanne 1 ultérieurement. Le système serait alors complètement bloqué, car il serait impossible, de part l'insuffisance de l'énergie électrique stockée, de bouger la vanne 1 thermostatique de sorte à laisser passer du fluide pour produire l'énergie électrique nécessaire au fonctionnement ultérieur du procédé.

Ainsi, si la condition d'actionnement n'est pas favorable, l'actionneur ne sera pas bougé en fonction de la consigne donnée par le thermostat, bien que l'étape de repli 104 ait été engagée. Après l'étape de repli 104, la vanne 1 thermostatique ne redevient donc sensible à la consigne que si la condition d'actionnement est favorable. Si la condition d'actionnement est favorable, la vanne 1 sera bougée en fonction de la consigne. Ainsi, la vanne 1 est commandée en fonction de la consigne uniquement si la condition d'actionnement est favorable. L'étape consistant à commander le mouvement 101 de la vanne 1 en fonction d'une consigne est réalisée uniquement si la condition d'actionnement est favorable. Le mouvement de la vanne 1 lors de l'étape de repli 104 est le seul prévu lorsque la condition d'actionnement n'est pas favorable.

Dans un mode de réalisation du procédé, dans lequel la vanne 1 consiste en un clapet piloté dont la distance 8 par rapport à son siège 7 détermine le débit du fluide dans le radiateur, l'étape de repli 104 consiste à positionner le clapet piloté à proximité de son siège 7 mais sans contact avec lui, comme, par exemple, lorsque la distance 8 de la vanne 1 par rapport à son siège 7 est de l'ordre d'un millimètre, de sorte à permettre un passage de fuite dans le radiateur.

Le clapet est donc au moins légèrement éloigné de son siège 7 par l'étape de repli 104, de sorte que, même si le moyen d'accumulation 5 de l'énergie électrique est vide, ce qui rend le mouvement de la vanne 1 thermostatique impossible, le fluide chaud pourra légèrement circuler de sorte à produire de l'électricité, grâce à l'étape de production de l'énergie électrique 102 par transformation de l'énergie thermique, et remplir au moins en partie l'accumulateur pour une future manoeuvre de la vanne 1.

Dans une réalisation particulière, l'étape de repli 104 consiste à commander la vanne 1 jusqu'à placer le clapet piloté dans son siège 7 puis à commander la vanne 1 pour éloigner le clapet de son siège 7. Avantageusement, le procédé comprend, en outre, une étape consistant à identifier la position du clapet piloté, notamment grâce à un procédé électronique déterminant, en auto-apprentissage, les deux butées mécaniques, à savoir celle correspondant à la position complètement ouverte et celle correspondant à la position complètement fermée où la vanne 1 est contre son siège 7.

Dans un second mode de réalisation, dans laquelle la position fermée de la vanne 1 utilisée laisse circuler un débit de fuite, l'étape de repli 104 consiste à piloter la vanne 1 pour la placer dans sa position fermée. Ainsi, dès que la condition d'actionnement devient non favorable, la vanne 1 est mise, grâce à l'étape de repli 104, dans une configuration dans laquelle elle laisse circuler un débit de fuite, par construction.

Grâce à l'invention, il est donc possible d'obtenir un procédé de pilotage d'une vanne thermostatique pour installation de chauffage par circulation de fluide ne nécessitant pas d'apport en énergie électrique supplémentaire, de par l'utilisation d'un effet thermoélectrique utilisant l'écart de température entre le fluide et l'air ambiant. Le procédé intègre préférentiellement une étape de repli 104, dans laquelle la vanne 1 est rendue immobile, dans une position qui laisse une ouverture par laquelle un faible débit de fuite peut circuler, de sorte à créer, dès que du fluide chaud circule dans le radiateur, suffisamment d'énergie électrique pour la manoeuvre normale de la vanne 1. Ainsi, ce procédé n'est jamais bloqué à cause de la position de la vanne 1 empêchant toute recharge, mais est constamment opérationnel.

Bien entendu, l'invention n'est pas limitée au mode de réalisation décrit et représenté aux dessins annexés. Des modifications restent possibles, notamment du point de vue de la constitution des divers éléments ou par substitution d'équivalents techniques, sans sortir pour autant du domaine de protection de l'invention.

## Revendications

1. Procédé de pilotage d'une vanne (1) thermostatique d'un corps de chauffage à circulation de fluide, notamment un radiateur à eau chaude, dans lequel la vanne (1) est commandée en fonction d'une consigne, le procédé comprenant, en outre, une étape consistant à produire l'énergie électrique (102) pour la réalisation du procédé en utilisant un effet thermoélectrique, couramment appelé « Seebeck » ou « Peltier inversé », ainsi qu'une étape consistant à stocker l'énergie électrique produite (103) par cet effet thermoélectrique dans un moyen d'accumulation (5), et **caractérisé en ce qu'**il comprend, enfin, une étape de repli (104), consistant à rendre la vanne (1) immobile dans une position qui laisse une ouverture par laquelle un faible débit de fuite peut circuler.

2. Procédé de pilotage d'une vanne (1) thermostatique selon la revendication 1, **caractérisé en ce qu'**il comprend une étape consistant à évaluer une condition d'actionnement (105), ladite condition d'actionnement étant définie comme favorable si la valeur d'un paramètre ou de plusieurs paramètres parmi la température du fluide entrant, la quantité d'énergie stockée dans le moyen d'accumulation (5) et l'énergie ou la puissance électrique fournie par l'effet thermoélectrique, se trouve au-dessus d'un seuil limite.

3. Procédé de pilotage d'une vanne (1) thermostatique selon la revendication 2, **caractérisé en ce que** l'étape de repli (104) est effectuée si la condition d'actionnement n'est pas favorable.

4. Procédé de pilotage d'une vanne (1) thermostatique selon l'une quelconque des revendications 2 ou 3, **caractérisé en ce que** la vanne (1) est commandée en fonction de la consigne uniquement si la condition d'actionnement est favorable.

5. Procédé de pilotage d'une vanne (1) thermostatique selon l'une quelconque des revendications 1 à 4, **caractérisé en ce que** l'étape consistant à produire l'énergie électrique (102) consiste à produire l'énergie électrique à partir d'une différence de température entre, d'une part, le fluide chaud, directement ou non, comme, par exemple, au niveau de la canalisation d'alimentation en fluide chaud du corps de chauffage, et, d'autre part, une substance plus froide, telle que l'air environnant ou le fluide après son passage dans le radiateur.

6. Procédé de pilotage d'une vanne (1) thermostatique selon l'une quelconque des revendications 1 à 5, caractérisé en que le moyen d'accumulation (5) consiste en au moins un couple d'accumulateurs électriques, l'étape consistant à stocker l'énergie électrique produite (103) revenant alors à la stocker dans ledit au moins un couple d'accumulateurs électriques qui fournissent à leur tour l'énergie nécessaire pour la mise en oeuvre du procédé.

7. Procédé de pilotage d'une vanne (1) thermostatique selon l'une quelconque des revendications 1 à 6, dans lequel la vanne (1) consiste en un clapet piloté dont la distance (8) par rapport à son siège (7) détermine le débit du fluide dans le radiateur, **caractérisé en ce que** l'étape de repli (104) consiste à positionner le clapet piloté à proximité de son siège (7) mais sans contact avec lui, comme, par exemple, lorsque la distance (8) de la vanne (1) par rapport à son siège (7) est de l'ordre d'un millimètre, de sorte à permettre un passage de fuite dans le radiateur.

8. Procédé de pilotage d'une vanne (1) thermostatique selon la revendication 7, **caractérisé en ce que** l'étape de repli (104) consiste à commander la vanne (1) jusqu'à placer le clapet piloté dans son siège (7) puis à commander la vanne (1) pour éloigner le clapet de son siège (7).

9. Procédé de pilotage d'une vanne (1) thermostatique selon l'une quelconque des revendications 7 ou 8, **caractérisé en ce qu'**il comprend, en outre, une étape consistant à identifier la position du clapet piloté, notamment grâce à un procédé électronique déterminant, en auto-apprentissage, les deux butées mécaniques, à savoir celle correspondant à la position complètement ouverte et celle correspondant à la position complètement fermée où la vanne (1) est contre son siège (7).

10. Procédé de pilotage d'une vanne (1) thermostatique selon l'une quelconque des revendications 1 à 6, dans lequel la position fermée de la vanne (1) utilisée laisse circuler un débit de fuite, **caractérisé en ce que** l'étape de repli (104) consiste à piloter la vanne (1) pour la placer dans sa position fermée.

## Patentansprüche

1. Verfahren zum Steuern eines thermostatischen Ventils (1) eines Heizkörpers mit Fluidzirkulation, insbesondere eines Warmwasser-Heizkörpers, bei dem das Ventil (1) abhängig von einem Sollwert gesteuert wird, wobei das Verfahren außerdem einen Schritt, der darin besteht, die elektrische Energie (102) für die Durchführung des Verfahrens zu erzeugen, indem ein thermoelektrischer Effekt verwendet wird, der üblicherweise «Seebeck»- oder «Umgekehrter Peltier»-Effekt genannt wird, sowie einen Schritt, der darin besteht, die durch diesen thermoelektrischen Effekt erzeugte elektrische Energie (103) in einer Speichereinrichtung (5) zu speichern enthält, und **dadurch gekennzeichnet ist, dass** es schließlich einen Rückzugschritt (104) enthält, der darin besteht, das Ventil (1) in eine Konfiguration zu bringen, in der es immer eine zirkulation des Fluids erlaubt, insbesondere eine sehr geringe Zirkulation.

2. Verfahren zur Steuerung eines thermostatischen Ventils (1) nach Anspruch 1, **dadurch gekennzeichnet, dass** es einen Schritt enthält, der darin besteht, eine Betätigungsbedingung (105) zu bewerten, wobei die Betätigungsbedingung als günstig definiert wird, wenn der Wert eines Parameters oder mehrerer Parameter unter der Temperatur des eingehenden Fluids, der in der Speichereinrichtung (5) gespeicherten Energie und der Energie oder der elektrischen Leistung, die durch den thermoelektrischen Effekt geliefert wird, sich unter einer Grenzschwelle befindet.

3. Verfahren zur Steuerung eines thermostatischen Ventils (1) nach Anspruch 2, **dadurch gekennzeichnet, dass** der Rückzugschritt (104) durchgeführt wird, wenn die Betätigungsbedingung nicht günstig ist.

4. Verfahren zur Steuerung eines thermostatischen Ventils (1) nach einem der Ansprüche 2 oder 3, **dadurch gekennzeichnet, dass** das Ventil (1) abhängig von dem Sollwert nur gesteuert wird, wenn die Betätigungsbedingung günstig ist.

5. Verfahren zur Steuerung eines thermostatischen Ventils (1) nach einem der Ansprüche 1 bis 4, **dadurch gekennzeichnet, dass** der Schritt, der darin besteht, die elektrische Energie (102) zu erzeugen, darin besteht, die elektrische Energie ausgehend von einem Temperaturunterschied zwischen einerseits dem warmen Fluid, direkt oder nicht, wie zum Beispiel im Bereich der Versorgungsleitung des Heizkörpers mit warmem Fluid, und andererseits einer kälteren Substanz, wie zum Beispiel der Umgebungsluft oder dem Fluid nach seinem Durchgang durch den Heizkörper, zu erzeugen.

6. Verfahren zur Steuerung eines thermostatischen Ventils (1) nach einem der Ansprüche 1 bis 5, **dadurch gekennzeichnet, dass** die Speichereinrichtung (5) aus mindestens einem Paar von elektrischen Speichern besteht, wobei der Schritt darin besteht, die erzeugte elektrische Energie (103) zu speichern, was dann darauf hinausläuft, sie in dem mindestens einen Paar von elektrischen Speichern zu speichern, die ihrerseits die Energie liefern, die zur Durchführung des Verfahrens notwendig ist.

7. Verfahren zur Steuerung eines thermostatischen Ventils (1) nach einem der Ansprüche 1 bis 6, wobei das Ventil (1) aus einer gesteuerten Ventilklappe besteht, deren Abstand (8) zu ihrem Sitz (7) den Durchsatz des Fluids im Heizkörper bestimmt, **dadurch gekennzeichnet, dass** der Rückzugschritt (104) darin besteht, die gesteuerte Ventilklappe in der Nähe ihres Sitzes (7), aber ohne Kontakt mit ihm, zu positionieren, wie zum Beispiel, wenn der Abstand (8) des Ventils (1) bezüglich seines Sitzes (7) in der Größenordnung eines Millimeters liegt, um einen Leckdurchgang durch den Heizkörper zu erlauben.

8. Verfahren zur Steuerung eines thermostatischen Ventils (1) nach Anspruch 7, **dadurch gekennzeichnet, dass** der Rückzugschritt (104) darin besteht, das Ventil (1) zu steuern, bis die gesteuerte Ventilklappe in ihrem Sitz (7) angeordnet ist, und dann das Ventil (1) zu steuern, um die Ventilklappe von ihrem Sitz (7) zu entfernen.

9. Verfahren zur Steuerung eines thermostatischen Ventils (1) nach einem der Ansprüche 7 oder 8, **dadurch gekennzeichnet, dass** es außerdem einen Schritt enthält, der darin besteht, die Stellung der gesteuerten Ventilklappe zu erkennen, insbesondere mit Hilfe eines elektronischen Verfahrens, das durch Selbstlernen die zwei mechanischen Anschläge bestimmt, nämlich denjenigen, der der vollständig offenen Stellung entspricht, und denjenigen, der der vollständig geschlossenen Stellung entspricht, in der das Ventil (1) gegen seinen Sitz (7) anliegt.

10. Verfahren zur Steuerung eines thermostatischen Ventils (1) nach einem der Ansprüche 1 bis 6, bei dem die geschlossene Stellung des verwendeten Ventils (1) einen Leckdurchsatz zirkulieren lässt, **dadurch gekennzeichnet, dass** der Rückzugschritt (104) darin besteht, das Ventil (1) zu steuern, um es in seiner geschlossenen Stellung anzuordnen.

## Claims

1. Method for controlling a thermostatic valve (1) of a fluid-circulation heating body, notably a hot-water radiator, in which the valve (1) is controlled according to a set point, the method also comprising a step consisting in producing the electric energy (102) for carrying out the method by using a thermoelectric effect, commonly called "Seebeck" or "reverse Peltier", and a step consisting in storing the electric energy produced (103) by this thermoelectric effect in an accumulation means (5) and **characterized in that** it comprises, finally, a fallback step (104) consisting in placing the valve (1) in a configuration in which it always allows a circulation of the fluid, notably a very slight circulation.

2. Method for controlling a thermostatic valve (1) according to Claim 1, **characterized in that** it comprises a step consisting in evaluating an actuation condition (105), the said actuation condition being defined as favourable if the value of a parameter or of several parameters amongst the temperature of the entering fluid, the quantity of energy stored in the accumulation means (5) and the energy or the electric power supplied by the thermoelectric effect, is above a threshold.

3. Method for controlling a thermostatic valve (1) according to Claim 2, **characterized in that** the fallback step (104) is carried out if the actuation condition is not favourable.

4. Method for controlling a thermostatic valve (1) according to either one of Claims 2 and 3, **characterized in that** the valve (1) is controlled according to the set point only if the actuation condition is favourable.

5. Method for controlling a thermostatic valve (1) according to any one of Claims 1 to 4, **characterized in that** the step consisting in producing the electric energy (102) consists in producing the electric energy from a temperature difference between, on the one hand, the hot fluid, directly or not, such as, for example, in the pipe for supplying the heating body with hot fluid, and, on the other hand, a colder substance, such as the surrounding air or the fluid after it has passed into the radiator.

6. Method for controlling a thermostatic valve (1) according to any one of Claims 1 to 5, **characterized in that** the accumulation means (5) consists of at least a pair of electric accumulators, the step consisting in storing the electric energy produced (103) then once again storing it in the said at least one pair of electric accumulators which in turn supply the energy necessary for the application of the method.

7. Method for controlling a thermostatic valve (1) according to any one of Claims 1 to 6, in which the valve (1) consists of a valve element the distance (8) of which relative to its seat (7) determines the flow rate of the fluid in the radiator, **characterized in that** the fallback step (104) consists in positioning the controlled valve element close to its seat (7) but without contact with it, such as, for example, when the distance (8) of the valve (1) relative to its seat (7) is of the order of one millimetre, so as to allow a trickle opening in the radiator.

8. Method for controlling a thermostatic valve (1) according to Claim 7, **characterized in that** the fallback step (104) consists in controlling the valve (1) until the controlled valve element is placed in its seat (7) and then in controlling the valve (1) in order to move the valve element away from its seat (7).

9. Method for controlling a thermostatic valve (1) according to either one of Claims 7 and 8, **characterized in that** it also comprises a step consisting in identifying the position of the controlled valve element, notably by virtue of an electronic method determining, by self-learning, the two mechanical abutments, namely that corresponding to the completely open position and that corresponding to the completely closed position in which the valve (1) is against its seat (7).

10. Method for controlling a thermostatic valve (1) according to any one of Claims 1 to 6, in which the closed position of the valve (1) that is used allows a leakage flow to circulate, **characterized in that** the fallback step (104) consists in controlling the valve (1) to place it in its closed position.
